(19) Europäisches Patentamt
European Patent Office
Office européen des brevets

(11) Veröffentlichungsnummer: **0 367 086 A1**

(12) **EUROPÄISCHE PATENTANMELDUNG**

(21) Anmeldenummer: **89119801.2**

(51) Int. Cl.5: **G03F 7/031**

(22) Anmeldetag: **25.10.89**

(30) Priorität: **03.11.88 DE 3837324**

(43) Veröffentlichungstag der Anmeldung: **09.05.90 Patentblatt 90/19**

(84) Benannte Vertragsstaaten: **DE FR GB IT NL**

(71) Anmelder: **BASF Aktiengesellschaft**
**Carl-Bosch-Strasse 38**
**D-6700 Ludwigshafen(DE)**

(72) Erfinder: **Littmann, Dieter, Dr.**
**Neckarpromenade 36**
**D-6800 Mannheim 1(DE)**
Erfinder: **Telser, Thomas, Dr.**
**Langer Wiesenweg 13**
**D-6940 Weinheim(DE)**
Erfinder: **Koch, Horst, Dr.**
**Tiefenthaler Strasse 47**
**D-6718 Gruenstadt(DE)**
Erfinder: **Huemmer, Wolfgang, Dr.**
**Vischerstrasse 16**
**D-6703 Limburgerhof(DE)**
Erfinder: **Meister, Martin, Dr.**
**Ziegelofenweg 7**
**D-6720 Speyer(DE)**

(54) **Lichtempfindliches Aufzeichnungsmaterial.**

(57) Die Erfindung betrifft ein lichtempfindliches Aufzeichnungsmaterial, das ein Gemisch aus carboxylgruppenhaltigen Polymeren mit seitenständigen ethylenisch ungesättigten Gruppen, ein oder mehrere ethylenisch ungesättigte monomere Verbindungen, einen Photoinitiator und einen ß-Aminoalkohol enthält.

Es eignet sich zur Herstellung von Druckplatten.

EP 0 367 086 A1

## Lichtempfindliches Aufzeichnungsmaterial

Die Erfindung betrifft ein lichtempfindliches wasserentwickelbares Aufzeichnungsmaterial, das insbesondere zur Herstellung von Reliefdruckplatten geeignet ist und hohe Beständigkeit der daraus erhaltenen Druckformen gegenüber Druckfarben auf Wasser- und/oder Ölbasis aufweist.

Es sind zwar schon Druckplatten bekannt, die eine ausreichende Beständigkeit gegenüber Druckfarbe auf Wasserbasis besitzen, diese weisen jedoch gravierende Nachteile in ihrer Handhabung auf, zum Beispiel die Notwendigkeit der Verwendung von brennbaren (Ethanol/Wasser-Gemische, s. DE-A-2722421), stark toxischen (Tetrachlorethylen, s. US-A-4423135) oder stark alkalischen Entwicklungsmedien (EP-A-0162570) oder man ist auf den Einsatz von Flüssigharzen angewiesen (DE-A-3319676).

Es ist zwar auch eine photoempfindliche Zusammensetzung bekannt, die mit reinem Wasser entwickelbar ist und gegenüber Druckfarbe auf Wasserbasis eine limitierte Auflagenfestigkeit aufweist (vgl. DE-A-3604402 bzw. EP-A-0261910); die darin beschriebenen konjugierten Dien-Copolymeren haben jedoch eine ungenügende Gummi-Elastizität und weisen für eine hohe Auflagenfestigkeit eine zu hohe Quellung in Druckfarbe auf Wasserbasis auf.

Aufgabe der vorliegenden Erfindung ist es, verbesserte, lichtempfindliche, schichtenförmige Aufzeichnungsmaterialien, insbesondere für den flexographischen Anwendungsbereich, aufzuzeigen. Aus diesen schichtenförmigen Aufzeichnungsmaterialien sollen in einfacher Weise Reliefformen herstellbar sein, die eine besonders hohe Resistenz gegenüber Druckfarbe auf Öl-und Wasserbasis aufweisen.

Diese Aufgabe wird erfindungsgemäß durch wasserentwickelbare, photovernetzbare bzw. photopolymerisierbare elastische schichtenförmige Aufzeichnungsmaterialien gelöst, die enthalten:

- mindestens ein carboxylgruppenhaltiges polymeres Bindemittel mit seitenständigen olefinisch ungesättigten Gruppen,
- mindestens ein photopolymerisierbares Monomeres mit einem oder mehreren ethylenisch ungesättigten Resten,

mindestens einen ß-Aminoalkohol bestimmter Zusammensetzung und einen Photopolymerisations-Initiator, sowie gegebenenfalls weitere übliche Hilfs- und Zusatzstoffe.

Gegenstand der vorliegenden Erfindung ist daher ein lichtempfindliches Aufzeichnungsmaterial, das im unbelichteten Zustand wasserlöslich oder zumindest wasserdispergierbar, im belichteten Zustand jedoch wasserunlöslich ist, im wesentlichen bestehend aus

(a) einem oder mehreren carboxylgruppenhaltigen Polymeren mit mittleren Molekulargewichten (Gewichtsmittel) $\overline{M}_n$ zwischen 5000 und 1 000 000 und seitenständigen ethylenisch ungesättigten Gruppen,

(b) einem oder mehreren photopolymerisierbaren nicht gasförmigen ein- oder mehrfach ethylenisch ungesättigten monomeren organischen Verbindungen,

(c) mindestens einem Amin und

(d) mindestens einem Photopolymerisationsinitiator, das dadurch gekennzeichnet ist, daß als Amin (c) ein ß-Aminoalkohol der allgemeinen Formel (I)

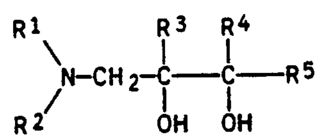

(I)

eingesetzt wird, worin $R^1$, $R^2$, $R^3$ und $R^4$ untereinander gleich oder verschieden sind und für H oder Alkylreste mit 1 bis 6 Kohlenstoffatomen stehen und $R^5$ für H, einen Alkylrest mit 1 bis 3 Kohlenstoffatomen, $-CH_2-OH$, $-CH_2-CH_2-OH$, $-(CH_2-O)_nR^6$, $-(CH_2-CH_2-O)_nR^6$,

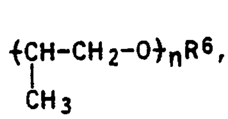

$-(C_4H_8-O)-R^6$ mit $R^6$ = H oder Alkylrest mit 1 bis 5 Kohlenstoffatomen und n = 1 bis 20 oder einen photopolymerisierbaren ethylenisch ungesättigten Rest steht.

Polymere (a) sind insbesondere Umsetzungsprodukte von Copolymerisaten aus Ethylen, Acrylsäure oder Methacrylsäure und einem oder mehreren Monomeren aus der Gruppe der Vinylester, Vinylether,

Acrylsäureester, Methacrylsäureester, Acrylsäureamide und Methacrylsäureamide mit einer Verbindung der allgemeinen Formel (II)

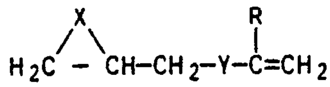

(II)

worin R = H oder $CH_3$,
X = O, S oder NH,
Y = eine $-O-\overset{O}{\overset{\|}{C}}-$, $-\overset{H}{N}-\overset{O}{\overset{\|}{C}}-$, -O- oder eine
$C_1$- bis $C_{10}$-Alkandiylgruppe bedeuten,
sowie Umsetzungsprodukte von Copolymerisaten aus

($a_1$) einem konjugierten Dien mit 4 bis 6 Kohlenstoffatomen

($a_2$) einer $\alpha,\beta$-ethylenisch ungesättigten Carbonsäure und

($a_3$) einer oder mehreren polymerisierbaren ethylenisch ungesättigten monomeren organischen Verbindungen, die von den unter ($a_1$) und ($a_2$) genannten verschieden sind, mit einer Verbindung der oben bereits genannten Formel (II).

Bevorzugte Aufzeichnungsmaterialien sind Gemische, die im wesentlichen bestehen aus
45 bis 90 Gew.-% des oder der Polymeren (a)
1 bis 40 Gew.-% des oder der monomeren organischen Verbindungen (b)
3 bis 15 Gew.-% des oder der ß-Aminoalkohole (c) und
0,01 bis 10 Gew.-% des oder der Photopolymerisationsinitiatoren (d),
wobei die Summe der unter (a) bis (d) angegebenen Prozentzahlen 100 ist, sowie gegebenenfalls weiteren üblichen Hilfs- und Zusatzstoffen.

Diese können vorzugsweise als Polymere (a) Umsetzungsprodukte von Copolymerisaten aus
30 bis 70 Gew.-% Ethylen,
5 bis 50 Gew.-% Acrylsäure oder Methacrylsäure und
5 bis 40 Gew.-% eines oder mehrerer Monomeren aus der Gruppe der Vinylester, Vinylether, Acrylsäureester, Methacrylsäureester, Acrylsäureamide und Methacrylsäureamide,
wobei die Summe der obengenannten Prozentzahlen 100 ist, mit einer Verbindung der allgemeinen Formel (II) sowie Umsetzungsprodukte von Copolymerisaten aus

($a_1$) 5 bis 95 Mol-% eines konjugierten Diens mit 4 bis 6 Kohlenstoffatomen,

($a_2$) 1 bis 50 Mol-% einer $\alpha,\beta$-ethylenisch ungesättigten Carbonsäure und

($a_3$) 5 bis 60 Mol-% eines oder mehrerer polymerisierbarer ethylenisch ungesättigter monomerer organischer Verbindungen, die von den unter ($a_1$) und ($a_2$) genannten verschieden sind, wobei die Summe der unter ($a_1$) bis ($a_3$) genannten Molprozentzahlen 100 ist, mit einer Verbindung der allgemeinen Formel (II) mit der Maßgabe, daß jeweils 1 bis 70 % der Carboxylgruppen des Copolymerisats mit einer Verbindung er Formel (II) umgesetzt sind, enthalten.

Gegenstand der vorliegenden Erfindung ist auch ein Verfahren zur Herstellung von Druckplatten, die gegen Wasser- und Ölfarben beständig sind, wobei erfindungsgemäßes lichtempfindliches Aufzeichnungsmaterial, gegebenenfalls in gelöster Form, in einer Schichtdicke von 200 µm bis 6 mm auf einen dimenstionsstabilen Träger aufgetragen und gegebenenfalls vorhandenes Lösungsmittel entfernt wird.

Die erfindungsgemäßen lichtempfindlichen Aufzeichnungsmaterialien lassen sich auf vorteilhafte Weise herstellen und verarbeiten. Es lassen sich so wasserentwickelbare Druckplatten mit Reliefschichten von sehr hoher Relieftiefe mit gutem Flankenaufbau herstellen. Die damit erhältlichen Druckformen sind stabil gegenüber chemischen und physikalischen Einflüssen und besitzen hohe Beständigkeit gegen Druckfarben auf Öl- und Wasserbasis.

Hinsichtlich der Aufbaukomponenten der erfindungsgemäßen Aufzeichnungsmaterialien ist im einzelnen folgendes auszuführen.

(a) Als carboxylgruppenhaltige Bindemittel (a) kommen erfindungsgemäß carboxylgruppenhaltige Polymere mit mittleren Molekulargewichten (Gewichtsmittel) $\overline{M}_n$ zwischen 5000 und 1 000 000 und seitenständigen ethylenisch ungesättigten Gruppen in Betracht.

Bevorzugte carboxylgruppenhaltige Polymere (a) mit seitenständigen olefinisch ungesättigten Gruppen sind zum einen Umsetzungsprodukte von Copolymerisaten I aus:
Ethylen (30 bis 70 Gew.-%),
(Meth)Acrylsäure (5 bis 50 Gew.-%) und

einem oder mehreren Monomeren aus der Gruppe der Vinylester, Acrylsäureester, Vinylether, Acrylsäureamide, (Meth)Acrylsäureester und/oder Methacrylsäureamide (5 bis 40 Gew.-%) mit Verbindungen der bereits oben angegebenen Formel (II).

Die Darstellung der Copolymeren I kann z.B. nach der LDPE (= low density polyethylene)-Hochdruckpolymerisationsmethode bei Temperaturen von 200 bis 400 °C und einem Druck von mehr als 800 kg/cm$^2$ erfolgen (siehe z.B. DE-PS 23 41 462, US-PS 3 264 272 und DE-A-35 39 469). Als Comonomere geeignete Vinylester sind insbesondere solche der allgemeinen Formel (III)

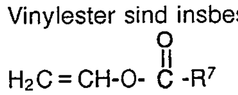 (III),

worin $R^7$ Alkyl- oder Cycloalkylreste mit 1 bis 10 Kohlenstoffatomen bedeutet, z.B.: Vinylacetat, Vinylpropionat, Vinylbutyrat, Valeriansäurevinylester oder Hexancarbonsäurevinylester. Bevorzugt ist Vinylacetat. Als Comonomere geeignete Vinylether sind insbesondere solche der allgemeinen Formel (IV)

$H_2C=CHOR^8$ (IV),

worin $R^8$ für einen Alkylrest mit 2 bis 8 Kohlenstoffatomen steht, z.B. Vinylethylether, Vinyl-1-propylether, Vinyl-2-propylether, Vinyl-1-butylether, Vinyl-2-butylether oder Vinyl-1-pentylether. Bevorzugt wird Vinyl-1-butylether.

Als Comonomere geeignete (Meth)Acrylsäureester und -amide sind insbesondere solche der allgemeinen Formel (V)

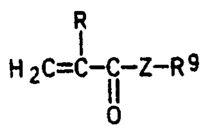 (V),

worin R = H oder Methyl, $R^9$ für einen Alkylrest mit 1 bis 10 Kohlenstoffatomen, einen Cycloalkylrest oder einen $\omega$-Methyl-poly(alkylenoxid)-$\alpha$-yl-Rest und Z für ein Sauerstoffatom oder eine $NR^{10}$-Gruppe mit $R^{10}$ = H oder $C_1$-$C_4$-Alkyl stehen.

Beispiele geeigneter (Meth)Acrylsäureester und/oder -amide sind Methylacrylat, Methylmethacrylat, Ethylacrylat, Propylacrylat, Propylmethacrylat, n-Butylacrylat, n-Butylmethacrylat, n-Pentylacrylat, n-Pentylmethacrylat, n-Hexylacrylat, n-Hexylmethacrylat, t-Butylacrylat, Cyclohexylacrylat, Cyclohexylmethacrylat, 2-Ethylhexylacrylat, 2-Ethylhexylmethacrylat, Dicyclopentadienylacrylat, $\omega$-Methyl-poly(ethylenoxid-$\alpha$-yl-(meth)acrylat, $\omega$-Methyl-poly(propylen-1,2-oxid)-$\alpha$-yl-(meth)-acrylat, $\omega$-Methyl-poly(propylen-1,3-oxid)-$\alpha$-yl-(meth)acrylat u.a., N-Ethylacrylamid, N-Methyl-N-butylmethacrylamid, N-Ethyl-N-(2-ethylhexyl)-acrylamid u.a. bevorzugt sind n-Butylacrylat, 2-Ethylhexylacrylat, $\omega$-Methyl-poly(ethylenoxid)-$\alpha$-yl-acrylat und Dicyclopentadienylacrylat, von denen die ersten drei besonders bevorzugt sind.

Bevorzugte Copolymerisate I sind Ethylen/(Meth)Acrylsäure-Copolymerisate die n-Butylacrylat, 2-Ethylhexylacrylat und/oder $\omega$-Methyl-poly(ethylenoxid)-$\alpha$-yl-acrylat als Comonomere einpolymerisiert enthalten. Besonders vorteilhafte Copolymerisate I haben eine Shore A Härte von über 10 und insbesondere von 15 bis 75.

Bevorzugte carboxylgruppenhaltige Polymere (a) mit seitenständigen elefinisch ungesättigten Gruppen sind zum anderen Umsetzungsprodukte von Copolymerisaten II aus

($a_1$) - einem konjugierten Dien mit 4 bis 6 Kohlenstoffatomen (50 bis 90 %)

($a_2$) - einer $\alpha$,ß-ethylenisch ungesättigten Carbonsäure (5 bis 40 %)

($a_3$) - einem oder mehreren polymerisierbaren ungesättigten monomeren organischen Verbindungen, die von den unter ($a_1$) und ($a_2$) genannten verschieden sind (0 bis 50 %) mit Verbindungen der bereits oben angegebenen Formel (II).

Als konjugierte Dien-Monomere ($a_1$) geeignete Verbindungen sind beispielsweise 1,3-Butadien, Isopren, Chloropren und 1,3-Pentadien.

Als ethylenisch ungesättigte Carbonsäure ($a_2$) kommen Acrylsäure bzw. Methacrylsäure, Maleinsäure, Fumarsäure, Monoalkylmaleinsäurehalbester und Itaconsäure in Frage. Bevorzugt ist Methacrylsäure.

Als Comonomere geeignete olefinisch ungesättigte Verbindungen ($a_3$) sind beispielsweise Styrol, Acrylsäure- bzw. Methacrylsäureester sowie Acrylsäure- bzw. Methacrylsäureamide wie sie beispielsweise bereits oben unter der allgemeinen Formel (V) angeführt sind und Vinylether, wie sie beispielsweise oben unter der allgemeinen Formel (IV) genannt sind.

Die Darstellung der Copolymerisate II kann beispielsweise durch radikalische Emulsionspolymerisation erfolgen.

Zur Kontrolle des Molekulargeiwchts der Copolymerisate II kann man der Monomerenmischung bei der

Emulsionspolymerisation üblicherweise noch einen Regler, wie beispielsweise t-Dodecylmercaptan, in einem Anteil von 0,1 bis 5 g pro 100 g Monomer zugeben. Die Zugabe der einzelnen Monomeren sowie die der übrigen Polymerisationshilfsstoffe (Initiator, Emulgator, Regler, etc.) kann in einem Zulauf vor Beginn der Polymerisation oder portionsweise in verschiedenen Zuläufen erfolgen. Die Emulsionspolymerisation wird im allgemeinen in einer sauerstofffreien Atmosphäre bei Temperaturen von 0 bis 100 °C durchgeführt. Die Polymerisation kann kontinuierlich oder im Batchbetrieb durchgeführt werden. Der Feststoffgehalt der erhaltenen Dispersionen liegt im allgemeinen zwischen 30 und 60 %.

Zur Gewinnung der reinen Copolymerisate II wird zweckmäßigerweise das in der Dispersion enthaltene Wasser entfernt. Hierzu können die üblichen Verfahren wie Gefriertrocknung, Entgasung in einem Extruder oder azeotrope Destillation angewandt werden.

Bevorzugte Copolymerisate II sind Butadien-Methacrylsäure-Copolymerisate, die Methylmethacrylat, Butylacrylat und/oder Laurylacrylat als zusätzliche Comonomere einpolymerisiert enthalten. Besonders vorteilhafte Copolymerisate II weisen eine Shore A Härte von 5 bis 30 auf.

In einer vorteilhaften Verfahrensweise kann die Einführung der seitenständigen olefinisch ungesättigten Gruppe in die Copolymerisate I und II durch partielle Umsetzung der Carboxylgruppen mit Oxiran-2-yl, Glycidyl-, Thiiran-2-yl- oder Aziridin-2-yl-Verbindungen erfolgen.

Die Umsetzung von Carboxylgruppen enthaltenden Verbindungen mit Oxiran-2-yl-, Thiiran-2-yl- oder Aziridin-2-yl-Verbindungen unter Ringöffnung und Bildung eines α-Hydroxy-, α-Mercapto- und α-Amino-Esters ist an sich bekannt und wird beispielsweise in der Firmenschrift "Reactive Monomers", Nissan Blemmer G, High Polymer Modifiers (Nippon Oil and Fats, Co. Ltd.) aus dem Jahr 1968 beschrieben. Ferner ist es bekannt, daß anstelle von Oxiran-2-yl-Verbindungen auch Glycidyl-Verbindungen eingesetzt werden können. Vorteilhafterweise setzt man die Copolymerisate I oder II mit diesen Verbindungen in Lösungsmitteln wie Tetrahydrofuran, Toluol, Ethylbenzol, Methylethylketon, Methylisobutylketon oder Gemischen aus denselben um. Zu den Lösungen der Copolymerisate I oder II fügt man gegebenenfalls p-Dimethylaminopyridin oder N-Methylimidazol als Katalysator und z.B. 2,5-Die-tert.-butyl-p-kresol oder N-Nitrosodiphenylamin als Inhibitor zu. Zu diesen Lösungen tropft man die gewünschte Menge an Oxiran-2-yl, Glycidyl-, Thiiran-2-yl oder Aziridin-2-yl-Verbindung mit einer solchen Geschwindigkeit, daß die Temperatur des Reaktionsgemisches bei 40 bis 110 °C liegt. Gegebenenfalls wird die Temperatur durch Heizen oder Kühlen eingestellt. Nach dem Zutropfen wird die Reaktionsmischung zweckmäßigerweise 3 bis 10 Stunden lang bei 50 °C nachgerührt und das Lösungsmittel in geeigneter Weise, beispielsweise durch Vakuumdestillation entfernt. In einer weiteren vorteilhaften Verfahrensweise kann man Copolymerisat I oder II zusammen mit den vorstehend genannten Verbindungen auf einem Kneter umsetzen, z.B. bei 125 bis 180 °C während 3 bis 60 Minuten, oder die Reaktion in einem Zweischneckenextruder durchführen, vorteilhafterweise mit einer Verweilzeit von 5 bis 10 Minuten.

Die Oxiran-2-yl-, Glycidyl-, Thiiran-2-yl- oder Aziridin-2-yl-Verbindungen der allgemeinen Formel (II) werden vorzugsweise in solchen Mengen mit dem carboxylgruppenhaltigen Poylmeren I oder II umgesetzt, daß 1 bis 70, vorzugsweise 5 bis 40 % der Carboxylgruppen des Polymeren mit einer Verbindung der allgemeinen Formel (II) umgesetzt werden.

Bevorzugte Verbindungen der allgemeinen Formel (II), die zur Einführung seitenständiger ethylenisch ungesättigter Gruppen in die carboxylgruppenhaltigen Copolymerisate dienen, sind Glycidylacrylat und Glycidylmethacrylat.

Es kommen auch Gemische von unterschiedlichen carboxylgruppenhaltigen Polymeren der oben genannten Art in Frage.

Komponente (a) ist im lichtempfindlichen Aufzeichnungsmaterial im allgemeinen in Mengen von 45 bis 90, vorzugsweise 50 bis 85 Gew.-% enthalten.

(b) Als photopolymerisierbare, nicht gasförmige ein- oder mehrfach ethylenisch ungesättigte monomere organische Verbindungen kommen die für photopolymerisierbare Aufzeichnungsmaterialien üblichen in Frage, soweit sie mit den anderen Komponenten des Gemisches verträglich sind.

Geeignete verträgliche photopolymerisierbare Monomere (b) besitzen im allgemeinen einen Siedepunkt von über 100 °C bei Atmosphärendruck und ein Molgewicht von bis zu 3000, insbesondere von bis zu 2000. Geeignet sind z.B. die Ester der Acrylsäure und/oder Methacrylsäure mit ein- oder mehrwertigen Alkoholen wie Butylacrylat, Butylmethacrylat, 2-Ethylhexylacrylat, Lauryl(meth)acrylat, Ethylenglykol-di-(meth)acrylat, Butandiol-1,4-di(meth)acrylat, 3-Methylenpentandiol-di(meth)acrylat, 2-Hydroxipropyl(meth)-acrylat, 2-Hydroxiethyl(meth)acrylat, 1,6-Hexandiol-di(meth)acrylat, 1,1,1-Trimethylolpropan-tri(meth)acrylat, Di-, Tri- und Tetraethylenglykol-di(meth)acrylat, Tripropylenglykol-di(meth)acrylat oder Pentaerythrit-tetra-(meth)acrylat, Poly(ethylenoxid)-di(meth)acrylat, ω-methyl-poly(ethylenoxid)-α-yl-(meth)acrylat, Dihydrodicyclopentadienylacrylat, Isobornylacrylat, N,N-Diethylaminoethylacrylat oder ein Umsetzungsprodukt aus 1 Mol Glycerin, 1 Mol Epichlorhydrin und 3 Mol Acrylsäure; die Vinylester aliphatischer Monocarbonsäuren,

wie Vinyloleat; die Vinylether von Alkoholen, wie Octadecylvinylether und Butandiol-1,4-divinylether; die Diester von Fumar- und Maleinsäure, die Umsetzungsprodukte aus OH-terminierten oligomeren Polybutadienen mit Maleinsäure oder (Meth)Acrylsäure, d.h. oligomere Polybutadiene mit aktivierten, photopolymerisierbaren olefinischen Doppelbindungen.

In den erfindungsgemäßen Aufzeichnungsmaterialien wird Komponente (b), die aus einzelnen Monomeren oder Monomerenmischung bestehen kann, in einer Menge von 1 bis 40, vorteilhafterweise 3 bis 30 und insbesondere 5 bis 20 Gew.-%, bezogen auf die Gesamtmenge des Aufzeichnungsmaterials eingesetzt.

(c) Als Komponente (c) werden ß-Aminoalkohole der allgemeinen Formel (I)

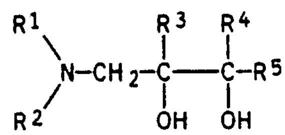 (I)

eingesetzt, worin die Reste $R^1$ bis $R^5$ die bereits oben angegebene Bedeutung haben. Beispiele für besonders bevorzugte ß-Aminoalkohole sind:
2,3-Dihydroxyaminopropan; 2,3-Dihydroxy-N-methylaminopropan; 2,3-Dihydroxy-N,N-dimethylaminopropan; 2,3-Dihydroxy-N,N-diethyl aminopropan; 2,3-Dihydroxy-N,N-methylethylaminopropan; 2,3-Dihydroxy-N,N-dipropylaminopropan; 2,3-Dihydroxy-N,N-diethylaminobutan; 2,3-Dihydroxy-N,N-diethylaminopentan; 2,3-Dihydroxy-N,N-diethylaminohexan; N,N-Diethyl-2,3-dihydroxy-prop-3-yl[ω-hydroxy-poly(ethylenoxid)-1-yl]-amin.

Der Rest $R^5$ in der allgemeinen Formel (I) kann auch ein photopolymerisierbarer ethylenisch ungesättigter Rest sein, beispielsweise ein Rest der Formel

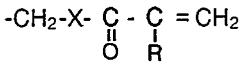

worin X = O, S oder NH oder

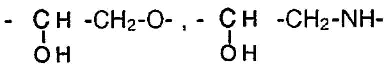

oder ein Rest der Formel

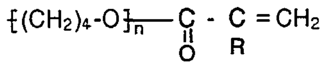

mit R = H oder $CH_3$
und n = 1 bis 20.

Diese Verbindungen haben den Vorteil, daß sie einerseits die Verträglichkeit der Rezepturbestandteile erhöhen, andererseits zu besonders schnell entwickelbaren lichtempfindlichen Schichten führen, die im belichteten Zustand eine besonders hohe Beständigkeit gegenüber Druckfarben auf Öl- und Wasserbasis aufweisen.

(d) Als Photopolymerisationsinitiatoren (d) eignen sich ebenfalls die für lichtempfindliche Aufzeichnungsmaterialien üblichen, mit den anderen Komponenten (a) bis (c) verträglichen.

Beispiele geeigneter verträglicher Photoinitiatoren sind Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethyl-acetal; oder Acylarylphosphinoxide wie 2-Dimethoxibenzoyl-diphenylphosphinoxid, 2,4,6-Trimethylbenzoyl-diphenylphosphinoxid, 2,4,6-Trimethylbenzoyl-phenylphosphinsäureethylester oder 2,4,6,-Trimethylbenzoyl-phenylphosphinsäure-Natrium-Salz oder substituierte und unsubstituierte Chinone wie Ethylanthrachinon, Benzanthrachinon, Benzophenon oder 4,4′-Bis(dimethylamino)benzophenon. Sie können allein oder im Gemisch miteinander oder in Verbindung mit Coinitiatoren verwendet werden, z.B. Ethylanthrachinon mit 4,4′-Bis(dimethylamino)-benzophenon, Benzoinmethylether mit Triphenylphosphin, Diacylphosphinoxide mit tertiären Aminen oder Acylarylphosphinoxide mit Benzildimethylacetal.

In den erfindungsgemäßen Aufzeichnungsmaterialien ist Komponente (d) im allgemeinen in einer Menge von 0,01 bis 10, vorzugsweise 0,1 bis 5 und insbesondere 0,3 bis 2 Gew.-%, bezogen auf die Gesamtmenge der Komponenten (a) bis (d) enthalten.

Die erfindungsgemäßen Aufzeichnungsmaterialien können noch weitere übliche Hilfs- und Zusatzstoffe enthalten, wie z.B. Weichmacher, Inhibitoren der thermisch initiierten Polymerisation, Farbstofe, Pigmente, photochrome Zusätze, Mittel zur Verbesserung der Reliefstruktur, Vernetzungshilfsmittel, Antioxidantien, Füllstoffe, Flußmittel und/oder Formtrennmittel.

Beispiele geeigneter verträglicher Weichmacher sind modifizierte und unmodifizierte Naturöle und

-harze, wie praffinische oder naphthenische Öle, sowie Erdölharze oder Pentaerythritolester von hydriertem Kollophonium; Alkyl-, Alkenyl-, Arylalkyl- oder Arylalkenylalkoholester von Säuren, wie Zitronensäure, Essigsäure, Propionsäure, Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze wie Oligostyrol, oligomere Styrol-Butadien-Copolymerisate, Oligo-α-methylstyrol, oligomere α-Methylstyrol-Vinyltoluol-Copolymerisate, flüssige 1,2- oder 1,4-Oligobutadiene, Oligopentadiene, flüssige oligomere Acrylnitril-Butadien-Copolymerisate sowie Polyterpen-, Polyacrylat-, Polyester- oder Polyurethanharze, synthetische Polymere wie Polyethylen oder Ethylen-Propylen-Dien-Kautschuke; α-Methyl-oligo-(ethylenoxid); oder Sulfonamide. Derartige Weichmacher können in Mengen von 1 bis 25 Gew.-%, bezogen auf das Gemisch der Komponenten (a) bis (d) zugesetzt werden.

Geeignete verträgliche Inhibitoren der thermisch initiierten Polymerisation können im allgemeinen in einer Menge von 0,001 bis 2 Gew.-%, bezogen auf das Gemisch der Komponenten (a) bis (d), zugesetzt werden und weisen keine nennenswerte Eigenabsorption in dem aktinischen Bereich auf, in dem der Photoinitiator absorbiert. Beispiele geeigneter Inhibitoren sind Hydrochinon, p-Methoxyphenol, 2,6-Di-tert.-butyl-kresol, ß-Napthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosoamine wie N-Nitrosodiphenylamin, oder die Salze, beispielsweise die Kalium, Calcium-oder Aluminiumsalze, des N-Nitrosocyclohexylhydroxylamins.

Geeignete verträgliche Farbstoffe, Pigmente oder photochrome Zusätze können den Gemischen der Komponenten (a) bis (d) in einer Menge von 0,0001 bis 2 Gew.-% bezogen auf das Gemisch, zugesetzt werden. Sie dienen der Steuerung der Belichtungseigenschaften, der Identifizierung, der direkten Kontrolle des Belichtungsergebnisses oder ästhetischen Zwecken. Voraussetzung für die Auswahl und die Menge solcher Zusätze ist, daß sie - ebenso wie die Inhibitoren der thermisch initiierten Polymerisation - die Photopolymerisation der Gemische nicht stören. Geeignet sind z.B. die löslichen Phenazinium-, Phenoxazinium-, Acridinium- und Phenothiazinium-Farbstoffe. Diese Farbstoffe werden auch zusammen mit einer hinreichenden Menge eines Reduktionsmittels verwendet, welches den Farbstoff in Abwesenheit von aktinischem Licht nicht reduziert, bei Belichtung jedoch den Farbstoff im angeregten Elektronenzustand reduzieren kann. Beispiele solcher milden Reduktionsmittel sind Ascorbinsäure, Anethol, Thioharnstoff, z.B. Diethylallylthioharnstoff, inbesondere N-Allylthioharnstoff, sowie Hydroxylaminderivate, insbesondere Salze des N-Nitrosocyclohexyl-Hydroxylamins, vorzugsweise die Kalium-, Calcium- und Aluminiumsalze. Letztere können, wie erwähnt, zugleich als Inhibitoren der thermisch initiierten Polymerisation dienen. Die Reduktionsmittel werden im allgemeinen in Mengen von 0,005 bis 5 Gew.-%, bezogen auf das Gemisch, zugesetzt, wobei sich in vielen Fällen der Zusatz eines 3-bis 10-fachen der Menge an mitverwendetem Farbstoff bewährt hat.

Beispiele geeigneter verträglicher Mittel zur Verbesserung der Reliefstruktur der aus den Gemischen hergestellten Druckformen sind beispielsweise 9,9′-Dianthronyl und 10,10′-Bisanthron.

Als Vernetzungshilfsmittel können übliche und bekannte tri- und tetrafunktionelle Thiolverbindungen zugesetzt werden.

Zum Schutz vor oxidativem und thermooxidativem Abbau durch Luftsauerstoff können auch noch wirksame Mengen an geeigneten verträglichen Antioxidantien zugesetzt werden, z.B. sterisch gehinderte Monophenole wie 2,6-Di-tert.-butyl-p-kresol; alkylierte Thiobis- und Alkylidenbisphenole wie 2,2′-Methylen-bis-(4-methyl-6-tert.-butylphenol) oder 2,2′-Bis-(1-hydroxi-4-methyl-6-tert.-butylphenyl)sulfid; Hydroxibenzyle wie 1,3,5-Trimethyl-2,4,6-tris-(3,5-di-tert.-butyl-4-hydroxibenzyl)benzol; Triazine wie 2-(4-Hydroxi-3,5-tert.-butylanilino)-4,6-bis-(n-octylthio)-1,3,5-triazin; polymerisiertes Trimethyldihydrochinon; Zinkdibutyldithiocarbamat; Dilaurylthiodipropionat; oder Phosphite wie Tris(nonylphenyl)phosphit. Von Vorteil sind Mengen 0,001 bis 5 Gew.-%, bezogen auf das Gemisch der Komponenten (a) bis (d).

Beispiele geeigneter verträglicher, aber nicht molekulardispers einmischbarer, polymerer oder nicht polymerer organischer und anorganischer Füllstoffe oder Verstärkungsfüllstoffe sind solche, die für die Wellenlängen des zur Belichtung der erfindungsgemäßen Gemische verwendeten Lichts im wesentlichen durchlässig sind, dieses nicht streuen und in ihrem Brechungsindex weitgehend dem betreffenden Gemisch angepaßt sind, z.B. Polystyrol, organophiles Siliciumdioxid, Bentonit, Kieselsäure, organophiles Aluminiumoxid, Glaspulver, kolloidaler Kohlenstoff sowie verschiedene Arten von Farbstoffen und Pigmenten. Diese Zusatzstoffe werden in Mengen verwendet, die mit den gewünschten Eigenschaften der erfindungsgemäßen Materialien variieren. Die Füllstoffe haben den Vorteil, daß sie die Festigkeit der Gemische auf der Basis der erfindungsgemäßen lichtempfindlichen Schichten verbessern, die Klebrigkeit verringern helfen und unter Umständen als farbgebende Mittel wirksam sind.

Ferner können geeignete Flußmittel wie Calciumstearat und/oder Formtrennmittel wie Talkum in wirksamen Mengen zugesetzt werden.

Der Anteil der gegebenenfalls mitzuverwendenden Hilfs- und Zusatzstoffe soll im allgemeinen 50, insbesondere 30 Gew.-% der Gesamtmenge des Gemisches der Komponenten (a) bis (d) mit den Hilfs-und Zusatzstoffen nicht überschreiten.

Die Herstellung der erfindungsgemäßen lichtempfindlichen Aufzeichnungsmaterialien kann durch Zusammengeben der gewünschten Menge der Komponenten (a) bis (d) und gegebenenfalls weitere Zusätze in Lösung oder in Substanz erfolgen, wobei die üblichen und bekannten Misch-, Knet- und Lösungstechniken angewendet werden können.

Die so erhaltenen Gemische können direkt zu durch Photopolymerisation vernetzbaren Druckplatten oder Reliefdruckplatten weiterverarbeitet werden. Dazu werden sie in üblicher Weise durch Gießen aus einer Lösung, Heißpressen, Kalandrieren oder Extrudieren zu Schichten der gewünschten Dicke geformt. Die Dicke richtet sich in erster Linie nach dem Verwendungszweck der Schichten. Sie variiert im allgemeinen von 0,001 bis 7, insbesondere 0,025 bis 6,5 mm. Druckplatten, welche Schichten dieser Dicke aufweisen, sind für die Mehrzahl der Drucktechniken geeignet.

Die Schichten können als solche zu photopolymerisierbaren Druckplatten, insbesondere Reliefdruckplatten verarbeitet werden; es ist jedoch vorteilhaft, sie im Verbund mit anderen schichtförmigen Materialien herzustellen und dann erst weiterzuverarbeiten. Ein solcher Verbund wird allgemein als "Mehrschichtenelement" und die darin enthaltene Schicht des erfindungsgemäßen Aufzeichnungsmaterials als "reliefbildende Schicht (RS)" bezeichnet.

Üblicherweise enthält ein solches Mehrschichtenelement eine reliefbildende Schicht (RS), die mit einem dimensionsstabilen Träger (T) haftfest oder leicht ablösbar verbunden ist. Der dimensionsstabile Träger (T) wiederum kann mit einer weichelastischen Unterschicht (U) unterlegt sein. Des weiteren kann auf die dem Träger (T) abgewandten Seite der Schicht (RS) eine Deckschicht (DS) und/oder eine Deckfolie (DF) aufgebracht werden. Werden Deckschicht (DS) und Deckfolie (DF) gemeinsam verwendet, dann liegt (DS) der Schicht (RS) direkt auf, und es kann sich zwischen (DS) und (DF) noch eine Antihaftschicht (AS) befinden. Ferner kann eine haftfeste Verbindung zwischen (T) und (RS) und gegebenenfalls (RS) und (DF) mit Hilfe einer Haftschicht (HS) erreicht werden.

Als dimensionsstabile Träger (T) können Platten, Folien oder konische oder zylindrische Röhren (Sleeves) aus Metallen wie Stahl, Aluminium, Kupfer oder Nickel oder aus Kunststoffen wie Polyethylenterephthalat, Polybutylenterephthalat, Polyamid oder Polycarbonat verwendet werden. Daneben kommen noch Gewebe und Vliesse, z.B. Glasfasergewebe oder Verbundmaterialien aus z.B. Glasfasern und Kunststoffen wie Polyethylenterephthalat in Frage.

Als Haftschichten (HS) können mit Vorteil übliche und bekannte, etwa 0,5 bis 40 µm dicke Haftlackschichten verwendet werden.

Geeignete Deckschichten (DS) sind im allgemeinen 0,5 bis 20µm dick und können aus einem Polymeren bestehen, das lösliche, klebfreie, transparente und reißfeste Filme bildet, z.B. Polyamid, Copolyamid, Polyurethan, Polyvinylalkohol, Polyvinylpyrrolidon, Polyethylenoxid eines Molgewichts über $10^5$ oder Cyclokautschuk mit einem hohen Cyclisierungsgrad. Gegebenenfalls kann (DS) mattiert sein.

Geeignete Deckfolien (DF) sind im allgemeinen 20 bis 150 µm dick und bestehen z.B. aus einem Polymeren wie Polyamid oder Polyethylenterephthalat.

Geeignete Antihaftschichten (AS) sind im allgemeinen 0,1 bis 0,5 µm dick und bestehen beispielsweise aus Silikonharzen.

Werden als Schichtträger (T) stark reflektierende Platten oder Folien verwendet, dann können sie geeignete Lichthofschutzmittel wie Ruß oder Mangandioxid enthalten. Die Lichthofschutzmittel können aber auch als separate Schicht auf (T) aufgetragen werden oder in der Haftschicht (HS) oder der reliefbildenden Schicht (RS) enthalten sein.

Die Herstellung solcher Mehrschichtenelemente kann durch Auftragen der reliefbildenden Schicht (RS) auf den Träger (T) mittels Gießen aus Lösung, Heißpressen, Kalandrieren oder Extrudieren erfolgen. Auf dieses Zweischichtenelement können dann die anderen Schichten in bekannter Weise aufgebracht werden. Es ist aber auch möglich, die reliefbildende Schicht (RS) zuerst auf die mit einer Deckschicht (DS) bedeckten Seite einer Deckfolie (DF) aufzutragen und anschließend die unbedeckte Seite der Schicht (RS) mit dem Träger (T) haftfest oder ablösbar zu verbinden.

Aus den Schichten, die aus dem erfindungsgemäßen Aufzeichnungsmaterial bestehen, oder aus den Mehrschichtenelementen, die reliefbildende Schichten (RS) aus erfindungsgemäßem Aufzeichnungsmaterial enthalten, können durch Photopolymerisation vernetzte Druckplatten hergestellt werden.

Die Umwandlung der das erfindungsgemäße Aufzeichnungsmaterial enthaltenden Schichten in durch Photopolymerisation vernetzte Druckplatten erfolgt im allgemeinen - gegebenenfalls nach einer Vorbehandlung - durch bildmäßiges Belichten mit aktinischem Licht einer Wellenlänge zwischen 230 und 450 nm, vorteilhafterweise zwischen 300 und 450 nm durch aufgelegte Negativvorlagen hindurch, Auswaschen der

unbelichteten und daher unvernetzten Anteile der Druckplatten mit Hilfe von Wasser oder wäßrigen Lösungen und Trocknen der so erhaltenen Platten, die aus einer Reliefschicht (RS′) bestehen oder diese enthalten.

Geeignete Lichtquellen für aktinisches Licht sind handelsübliche UV-Fluoreszenzröhren, Quecksilbermittel-, -hoch- und -niederdruckstrahler, superaktinische Leuchtstoffröhren, Xenon-Impulslampen, mit Metalliodiden dotierten Lampen oder Kohlebogenlampen.

Die Dicke der Reliefschicht (RS′) der durch Photopolymerisation vernetzten Druckplatten variiert je nach Anwendungszweck von 0,001 bis 7 mm. Von Vorteil sind Dicken von 0,025 bis 6,5 mm.

Die in dieser Weise erhaltenen Druckplatten können auf Druckzylinder aufgebracht und für den Endlosdruck verwendet werden.

Die Gemische auf der Grundlage der erfindungsgemäßen lichtempfindlichen Aufzeichnungsmaterialien weisen bei ihrer Herstellung und Verarbeitung zahlreiche Vorteile auf. So lassen sie sich sehr leicht nach den üblichen Verfahren verarbeiten, wobei insbesondere ihre gute Dosierbarkeit in Krümelform das Beschicken von Extrudern erleichtert, wodurch sich im allgemeinen eine Mitverwendung von Trennmitteln erübrigt. Die verarbeiteten photopolymerisierbaren Aufzeichnungsmaterialien, Druckplatten und Reliefplatten sind klar und transparent, was vor allem erlaubt, photopolymerisierbare Druckplatten und Reliefplatten mit Reliefschichten (RS′) von sehr hoher Relieftiefe mit gutem Flankenaufbau herzustellen. Dies ist z.B. für das Bedrucken rauher, welliger Oberfläche, z.B. von Wellpappe, Kartonagen, oder Servietten unbedingt erforderlich. Reliefhöhen von über 3 mm sind daher ohne Probleme wie bei konventionell geprägten Gummiklischeees herstellbar, ohne daß es in der Tiefe der Schichten zum "Zupolymerisieren" kommt. Nicht zuletzt erlaubt die Klarheit der Gemische kurze Belichtungszeiten, ohne daß dies einen nicht akzeptablen Polymerisationsgradienten in den Massen oder in den Reliefschichten (RS′) der Druckplatten und Reliefplatten zur Folge hätte. Die belichteten Massen, Druckplatten und Reliefplatten sind stabil gegenüber chemischen und physikalischen Einflüssen und sie sind nicht klebrig. Überdies können die belichteten Druckplatten und Reliefplatten mit Wasser entwickelt werden. Die entwickelten Materialien besitzen eine hohe Beständigkeit gegenüber Druckfarbe auf Öl- und Wasserbasis und eine hohe Abriebfestigkeit, was sehr hohe Druckauflagen ermöglicht. Ihre Hauptvorteile sind ihre Wasserentwickelbarkeit bei gleichzeitiger hoher Beständigkeit gegenüber Druckfarbe auf Wasserbasis, ihre Ozonrißbeständigkeit und ihre hervorragende Dehnbarkeit und Reißfestigkeit.

Die in den folgenden Beispielen genannten Teile und Prozente sind, soweit nicht anders angegeben, Gewichtsteile bzw. Gewichtsprozente.

In den folgenden Beispielen ist unter "Säurezahl" die Menge von 100 %iger KOH in mg zu verstehen, welche zur Neutralisation der in 1 g Produkt enthaltenen Carbonsäuregruppen benötigt wird. Die Reißdehnung wurde nach DIN 53 504 bestimmt. Die Neigung zur Rißbildung wurde in einer Ozonkammer bei einer Ozonkonzentration von 50 ppm und bei einer Temperatur von 25 °C an 10 cm langen Proben, die einer 10 %igen Längendehnung unterworfen waren, bestimmt; das Kriterium für Ozonstabilität war hierbei, daß innerhalb von 10 Stunden keine Risse auftraten. Der "melt flow index" (MFI) wurde bei 190 °C mit einer Auflagekraft von 2,16 kp bestimmt.

Herstellung der Copolymerisate ($A_1$), ($A_2$) und ($A_3$)

Für die erfindungsgemaßen Beispiele wurden die Copolymerisate ($A_1$) und ($A_2$) nach der LDPE (= Low density polyethylene)-Hochdruckpolymerisationsmethode hergestellt. Das für die Herstellung von ($A_1$) verwendete Monomerengemisch bestand aus:

58 % Ethylen,
22 % Acrylsäure und
20 % 2-Ethylhexylacrylat.

Das für die Herstellung von ($A_2$) verwendete Monomerengemisch bestand aus:

51,5 % Ethylen,
20,3 % Acrylsäure,
19,4 % $\omega$-Methyl-poly(ethylenoxid)-$\alpha$-yl-acrylat ( $\overline{P}$ = 15, d.h. mit 15 Ethylenoxideinheiten) und
8,8 % 2-Ethylhexylacrylat.

Der melt flow index (MFI) des Copolymerisats ($A_1$) lag bei 20; seine Säurezahl wurde zu 142 ermittelt. Der MFI des Copolymerisats ($A_2$) lag bei 350; seine Säurezahl wurde zu 158 ermittelt.

Das Copolymerisat (A3) wurde durch Emulsionspolymerisation hergestellt. Das für die Herstellung von (A3) verwendete Monomerengemisch bestand aus:

55 % Butadien

25 % Methacrylsäure
15 % Methylmethacrylat
5 % Laurylacrylat.

Als Regler wurde dem Polymerisationsansatz 2 Gew.-% t-Dodecylmercaptan, bezogen auf die eingesetzte Monomerenmenge, hinzugefügt. Das durch Gefriertrocknung vom Wasser befreite Copolymerisat (A3) hatte eine Shore A Härte von 12. Die Säurezahl lag bei 179.

Herstellung des Copolymerisats ($A_4$) durch die Einführung seitenständiger ethylenisch ungesättigter Reste in das Copolymerisat ($A_1$).

1000 Teile des Copolymerisats ($A_1$) wurden zusammen mit 0,630 Teilen p-Dimethylaminopyridin und 0,630 Teilen 2,6-Di-tert.-butyl-p-kresol in 2000 Teilen trockenem Tetrahydrofuran bei 40 bis 50 °C gelöst. Zu dieser Lösung wurden innerhalb von 50 Minuten 38 Teile Glycidylmethacrylat zugetropft. Die resultierende Lösung wurde während 5 Stunden bei 50 °C gerührt. Nach dem Entfernen des Lösungsmittels erhielt man das transparente weichelastische Copolymerisat ($A_4$), dessen Carbonsäuregruppen zu 20 %, verestert waren. Das Copolymerisat (A4) enthielt weniger als 0,1 Gew.-% bezogen auf ($A_4$), an freiem Glycidylmethacrylat. Der Gehalt seiner freien Carbonsäuregruppen errechnete sich zu 0,25 Mol pro 100 g Produkt, was durch die Säurezahl von 140 bestätigt wurde.

Herstellung des Copolymerisats ($A_5$) durch die Einführung seitenständiger ethylenisch ungesättigter Reste in das Copolymerisat ($A_2$).

1000 Teile des Copolymerisats ($A_2$) wurden zusammen mit 0,630 Teilen p-Dimethylaminopyridin und 0,630 Teilen 2,6-Di-tert.-butyl-p-kresol in 2000 Teilen trockenem Tetrahydrofuran bei 40 bis 50 °C gelöst. Zu dieser Lösung wurden innerhalb von 50 Minuten 103 Teile Glycidylmethacrylat zugetropft. Die resultierende Lösung wurde während 5 Stunden bei 50 °C gerührt. Nach dem Entfernen des Lösungsmittels erhielt man das transparente weichelastische Copolymerisat ($A_5$), dessen Carbonsäuregruppen zu 26 % verestert waren. Das Copolymerisat ($A_5$) enthielt weniger als 0,1 Gew.-% bezogen auf ($A_5$), an freiem Glycidylmethacrylat. Der Gehalt seiner freien Carbonsäuregruppen errechnete sich zu 0,21 Mol pro 100 g Produkt, was durch die Säurezahl von 116 bestätigt wurde.

Herstellung des Copolymerisats ($A_6$) durch die Einführung seitenständiger ethylenisch ungesättigter Reste in das Copolymerisat ($A_3$).

1000 Teile des Copolymerisats ($A_3$) wurden zusammen mit 0,630 Teilen p-Dimethylaminopyridin und 0,630 Teilen 2,6-Di-tert.-butyl-p-kresol in 2000 Teilen trockenem Tetrahydrofuran bei 40 bis 50 °C gelöst. Zu dieser Lösung wurden innerhalb von 50 Minuten 82 Teile Glycidylmethacrylat zugetropft. Die resultierende Lösung wurde während 5 Stunden bei 50 °C gerührt. Nach dem Entfernen des Lösungsmittel erhielt man das transparente weichelastische Copolymerisat ($A_6$), dessen Carbonsäuregruppen zu 20 % verestert waren. Das Copolymerisat ($A_6$) enthielt weniger als 0,1 Gew.-%, bezogen auf ($A_6$), an freiem Glycidylmethacrylat. Der Gehalt seiner freien Carbonsäuregruppen errechnete sich zu 0,23 Mol pro 100 g Produkt, was durch die Säurezahl von 129 bestätigt wurde.

Herstellung und Weiterverarbeitung von erfindungsgemäßen photopolymerisierbaren Gemischen auf der Grundlage der Copolymerisate ($A_4$), ($A_5$) und ($A_6$)

Beispiel 1

Eine 70 %ige Lösung bestehend aus 70 Teilen des Polymerisats $A_4$, 5 Teilen Hexandioldiacrylat ($HDA_2$) 5 Gew.-Teilen Phenylglycidetheracrylat, 10 Teilen n-Butylphenylsulfonamid, 7 Teilen N,N-Diethylamino-2,3-propandiol, 0,2 Teilen 2,6-Di-tert.-butylkresol, 2 Teilen Benzildimethylketal und 0,006 Teilen Sudantiefschwarz BB (C.I.26150) in Toluol wurde auf mit Haftlack versehene Stahlbleche gegossen und über Nacht abgelüftet. Die so erhaltenen Mehrschichtenelemente wurden durch ein Standardnegativ

hindurch mit aktinischem Licht während 90 Sekunden bildmäßig belichtet. Die belichteten Mehrschichtenelemente wurden mit einem handelsüblichen Bürstenwascher unter Ausreiben mit Wasser bei 50 bis 60 °C entwickelt. Es resultierten photopolymerisierte Druckplatten, die einen Träger (T), eine Haftschicht (HS) und eine Reliefschicht (RS) aufweisen. Die Reliefschicht war 0,5 mm stark. Die Ergebnisse der Prüfung der Reliefschichten sind in der Tabelle zusammengefaßt.

Die Qualität der Reliefschichten (RS′) wurde visuell bestimmt und beurteilt, wobei die Wiedergabe feiner Bildelemente, die Planarität der druckenden Oberfläche, die Relieftiefe und der Flankenaufbau die Beurteilungskriterien waren. Für den Fall, daß alle Merkmale höchsten Qualitätsanforderungen genügten, wurde die Note "sehr gut", für den Fall, daß ein Merkmal nicht diese Anforderungen erfüllte, die Note "mäßig" und für den Fall, daß die Mehrzahl der Merkmale diesen Anforderungen nicht entsprach, die Note "unbrauchbar" erteilt.

Die gemäß Beispiel 1 hergestellten Druckplatten wurden auf Druckzylinder aufgespannt und zum Drucken auf einem üblichen Flexodruckwerk verwendet. Dabei erwiesen sich die Druckplatten als sehr gut farbführend, beständig gegenüber Druckfarbenlösungsmitteln, abriebfest, nicht rupfend und rißbeständig. Dadurch konnten Auflagen von über $10^5$ Drucken erreicht werden, ohne daß die Wiedergabequalität in irgendeiner Weise gelitten hätte. Selbst nach mehrwöchiger Lagerung lieferten die Druckplatten noch immer die gleichen ausgezeichneten Druckergebnisse.

Beispiel 2

Eine 70 %ige Lösung, bestehend aus 70 Teilen des Polymerisats $A_5$, 5 Teilen Hydroxypropylmethacrylat (HPMA), 5 Teilen Butandioldiacrylat ($BDA_2$), 10 Teilen n-Butylphenylsulfonamid, 7,5 Teilen Aminopropan-2,3-diol, 0,2 Teilen Di-tert.-butylkresol, 2 Teilen Benzildimethylketal (BDMK) und 0,006 Teilen Sudantiefschwarz BB (C.I.26150) in Toluol, wurde auf eine mit einer Haftlackschicht sowie Lichthofschutz versehenen 125 µm dicken Polyethylenterephthalatfolie gegossen und 72 Stunden lang abgelüftet. Das so erhaltene 3 mm starke Mehrschichtenelement wurde während 3 Minuten durch die Polyethylenterephthalat-Folie hindurch vollflächig vorbelichtet und anschließend mit einem handelsüblichen Flachbelichter durch ein Standardnegativ 15 Minuten hauptbelichtet. Das belichtete Mehrschichtenelement wurde mit einem handelsüblichen Bürstenwascher mit Wasser bei 50 bis 60 °C entwickelt. Es resultierten photopolymerisierte Druckplatten mit einer Gesamtstärke von 2,3 mm und einer Reliefdicke von 0,9 mm. Die Ergebnisse der Prüfung der Reliefschichten sind in der Tabelle zusammengefaßt.

Beispiel 3

Eine 60 %ige Lösung,bestehend aus 80 Teilen des Polymerisats ($A_6$), 7 Teilen Hexandioldiacrylat, 10 Teilen n-Butylphenylsulfonamid, 7 Teilen N,N-Diethylamino-2,3-propandiol, 0,2 Teilen 2,6-Di-tert.-butylkresol, 2 Teilen Benzildimethylketal und 0,006 Teilen Sudantiefschwarz BB (C.1.26150) in Tetrahydrofuran, wurde auf eine mit einer Haftlackschicht sowie Lichthofschutz versehene 125 µm dicke Polyethylenterephthalatfolie gegossen und 24 Stunden abgelüftet. Die so erhaltene 3 mm starke Schicht wurde anschließend 1 Stunde bei 50 °C getrocknet und mit einer 3 µm starken Schicht aus Polyvinylalkohol bedeckt.

Das so erhaltene Mehrschichtenelement wurde dann von der Rückseite her 120 Sekunden lang vollflächig belichet und anschließend durch ein Standardnegativ 15 Minuten bildmäßig belichet. Als Belichter wurde ein handelsüblicher 115 W Flachbelichter eingesetzt. Das belichtete Mehrschichtenelement wurde anschließend mit einem handelsüblichen Bürstenwascher in Wasser bei 30 °C zum Klischee entwickelt. Man erhielt eine flexible 3 mm starke Druckform mit einer Reliefhöhe von 700 µm. Die Härte der Druckform betrug 44 Shore A. Die Ergebnisse der Prüfung der Klischees sind in der Tabelle zusammengefaßt.

Beispiel 4

Herstellung eines photopolymerisierbaren Gemischs auf der Grundlage eines erfindungsgemäßen lichtempfindlichen Aufzeichnungsmaterials und seine Verwendung zur Herstellung einer photopolymerisierten Druckplatte.

Das Gemisch wurde durch Extrusion von
74 Teilen des Copolymerisats ($A_2$),
4,8 Teilen Glycidylmethacrylat,
0,03 Teilen Dimethylaminopyridin,
5 Teilen Hexandioldiacrylat,
10 Teilen eines Weichmachers (n-Butylphenylsulfonamid)
7 Teilen N,N-Dimethylaminopropan-2,3-diol
2 Teilen Benzildimethylacetal,
1,164 Teilen 2,6-Di-tert.-butyl-p-kresol und
0,006 Teilen Sudantiefschwarz BB (C.I. 26150)
auf einem Zweischneckenextruder bei 150 °C und bei einer Verweilzeit von 3 Minuten hergestellt. Das Gemisch wurde aus einer Breitschlitzdüse auf eine 125 µm dicke Polyethylenterephthalatfolie aufgetragen, mittels Kalanderwalzen auf eine Dicke von 3000 µm gebracht und mit einer 3 µm dicken Schicht aus Polyvinylalkohol bedeckt.

Das resultierende Mehrschichtenelement (Druckplatte) wurde während drei Minuten durch die Polyethylenterephthalatfolie hindurch vollflächig und danach während 15 Minuten durch eine der Polyvinylalkoholschicht aufgelegten Negativvorlage hindurch bildmäßig belichtet.

Nach dem Entfernen des Negativs wurde die Druckplatte mit Wasser bei 50 °C in einem Bürstenwascher entwickelt. Die so erhaltene photopolymerisierte Druckplatte wurde während 30 Minuten bei 40 °C in einem Umlufttrockenschrank getrocknet.

Die Druckplatte wies eine sehr gute Reliefschicht (RS′) mit einer Relieftiefe von 900 µm auf. Die Reliefkanten und -flanken waren sehr gut ausgebildet; es ließen sich weder Unterwaschungen noch Kantenausbrüche erkennen. Die Reliefschicht (RS′) genügte höchsten Qualitätsanforderungen. Sie wurde daher mit "sehr gut" benotet.

Vergleichsbeispiele

Herstellung und Weiterverarbeitung von photopolymerisierbaren Gemischen auf der Grundlage nicht erfindungsgemäßer lichtempfindlicher Gemische.

Vergleichsbeispiel 1

Es wurde wie in Beispiel 1 verfahren, nur daß anstelle des N,N-Diethylamino-2,3-propandiols Ethylendiamin verwendet wurde. Die Schichten quollen in Wasser stark an und waren nicht mit Wasser entwickelbar.

Vergleichsbeispiel 2

Es wurde wie in Beispiel 2 verfahren, nur daß anstelle von Aminopropan-2,3-diol Triethanolamin verwendet wurde. Beim Entwickeln der belichteten Platten mit Wasser im Bürstenwascher quoll die Platte sehr stark an. Kleine Reliefteile wurden beim Entwickeln von der Platte abgelöst. Darüber hinaus waren die Oberflächen der Reliefteile sehr rauh und mit vielen Mikrokratern (d = 5 bis 15 µm) übersät.

Vergleichsbeispiel 3

Es wurde wie in Beispiel 4 verfahren, nur daß anstelle von Dimethylaminopropan-2,3-diol Tri-n-butylamin verwandt wurde. Die Platte war nicht mit reinem Wasser entwickelbar.

Die Auswertung der Vergleichsversuche zeigt, daß die erfindungsgemäßen lichtempfindlichen Gemische dem bisherigen Stand der Technik überlegen sind.

Tabelle

Durch Photopolymerisation vernetzbare Gemische auf der Grundlage der erfindungsgemäßen lichtempfindlichen Aufzeichnungsmaterialien (Beispiele 1 bis 4), sowie der Vergleichsbeispiele 1 bis 3

| Beispiel Nr. | Amin | Quellung (2 Stunden) in $H_2O$ Gew.% | Quellung (2 Stunden) in Druckfarbe auf $H_2O$-Basis (Gew.-%) | Entwickelbarkeit in $H_2O$ bei 50-60°C |
|---|---|---|---|---|
| 1 | N,N-Diethylaminopropan-2,3-diol | 1,1 | 1,9 | ja<br>60 sec bei Relieftiefe von 0,5 mm |
| 2 | Aminopropan-2,3-diol | 2,5 | 2,9 | ja<br>180 sec bei Relieftiefe von 0,9 mm |
| 3 | N,N-Diethylaminopropan-2,3-diol | 2,2 | 2,5 | ja<br>240 sec bei Relieftiefe von 700 µm |
| 4 | N,N-Dimethylaminopropan-2,3-diol | 1,5 | 2,1 | ja<br>200 sec bei Relieftiefe von 0,9 mm |

Tabelle 1 (Forts.)

| Vergleichsbeispiel | | | | |
| --- | --- | --- | --- | --- |
| 1 | Ethylendiamin | 6,5 | 9,0 | nein |
| 2 | Triethanolamin -2,3-diol | 20,3 | 30,6 | ja 240 sec |
| 3 | Tri-n-butylamin | 6,2 | 8,1 | nein |

## Ansprüche

1. Lichtempfindliches Aufzeichnungsmaterial, das im unbelichteten Zustand wasserlöslich oder zumindest wasser-dispergierbar, im belichteten Zustand jedoch wasserunlöslich ist, im wesentlichen bestehend aus

(a) einem oder mehreren carboxylgruppenhaltigen Polymeren mit mittleren Molekulargewichten (Gewichtsmittel) $\overline{M}_n$ zwischen 5000 und 1 000 000 und seitenständigen ethylenisch ungesättigten Gruppen,

(b) einem oder mehreren photopolymerisierbaren nicht gasförmigen ein- oder mehrfach ethylenisch ungesättigten monomeren organischen Verbindungen,

(c) mindestens einem Amin und

(d) mindestens einem Photopolymerisationsinitiator,

dadurch gekennzeichnet, daß als Amin (c) ein ß-Aminoalkohol der allgemeinen Formel (I)

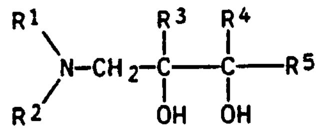 (I)

eingesetzt wird, worin $R^1$, $R^2$, $R^3$ und $R^4$ untereinander gleich oder verschieden sind und für H oder Alkylreste mit 1 bis 6 Kohlenstoffatomen stehen und

$R^5$ für H, einen Alkylrest mit 1 bis 3 Kohlenstoffatomen,

$-CH_2-OH$, $-CH_2-CH_2-OH$, $(CH_2-O)_nR^6$, $(CH_2CH_2-O)_nR^6$,

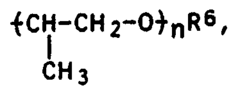

$(C_4H_8-O)_nR^6$ mit $R^6$ = H oder Alkylrest mit 1 bis 5 Kohlenstoffatomen und n = 1 bis 20,

oder einen photopolymerisierbaren ethylenisch ungesättigten Rest steht.

2. Lichtempfindliches Aufzeichnungsmaterial nach Anspruch 1, dadurch gekennzeichnet, daß als Polymer (a) ein Umsetzungsprodukt eines Copolymerisats aus Ethylen, Acrylsäure oder Methacrylsäure und einem oder mehreren Monomeren aus der Gruppe der Vinylester, Vinylether, Acrylsäureester, Methacrylsäureester, Acrylsäureamide und Methacrylsäureamide mit einer Verbindung der allgemeinen Formel (II)

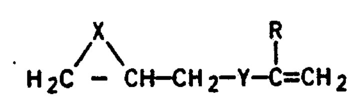 (II),

worin R = H oder $CH_3$,

X = O, S oder NH

Y = 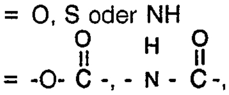, -O- oder eine

$C_1$- bis $C_{10}$-Alkandiylgruppe bedeuten,

eingesetzt wird.

3. Lichtempfindliches Aufzeichnungsmaterial nach Anspruch 1, dadurch gekennzeichnet, daß als Polymer (a) ein Umsetzungsprodukt eines Copolymerisats aus

($a_1$) einem konjugierten Dien mit 4 bis 6 Kohlenstoffatomen,

($a_2$) einer α,ß-ethylenisch ungesättigten Carbonsäure und

($a_3$) einer oder mehreren polymerisierbaren ethylenisch ungesättigten monomeren organischen Verbindungen, die von den unter ($a_1$) und ($a_2$) genannten verschieden sind,

mit einer Verbindung der allgemeinen Formel (II)

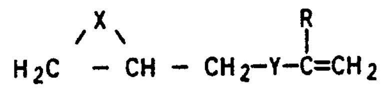 (II)

in der R, X und Y die in Anspruch 2 angegebene Bedeutung haben,
eingesetzt wird.

4. Lichtempfindliches Aufzeichnungsmaterial nach einem der Ansprüche 1 bis 3, dadurch gekennzeichnet, daß es im wesentlichen besteht aus
45 bis 90 Gew.-% des oder der Polymeren (a),
1 bis 40 Gew.-% des oder der monomeren organischen Verbindungen (b)
3 bis 15 Gew.-% des oder der ß-Aminoalkohole (c) und
0,01 bis 10 Gew.-% des oder der Photopolymerisationsinitiatoren (d),
wobei die Summe der unter (a) bis (d) angegebenen Prozentzahlen 100 ist, sowie gegebenenfalls weiteren üblichen Hilfs- und Zusatzstoffen.

5. Lichtempfindliches Aufzeichnungsmaterial nach einem der Ansprüche 1, 2 oder 4, dadurch gekennzeichnet, daß als Polymer (a) ein Umsetzungsprodukt eines Copolymerisats aus
30 bis 70 Gew.-% Ethylen,
5 bis 50 Gew.-% Acrylsäure oder Methacrylsäure und
5 bis 40 Gew.-% eines oder mehrerer Monomeren aus der Gruppe der Vinylester, Vinylether, Acrylsäureester, Methacrylsäureester, Acrylsäureamide und Methacrylsäureamide,
wobei die Summe der obengenannten Prozentzahlen 100 ist, mit einer Verbindung der allgemeinen Formel (II) eingesetzt wird, mit der Maßgabe, daß 1 bis 70 % der Carboxylgruppen des Copolymerisats mit einer Verbindung der Formel (II) umgesetzt sind.

6. Lichtempfindliches Aufzeichnungsmaterial nach einem der Ansprüche 1, 3 oder 4, dadurch gekennzeichnet, daß als Polymer (a) ein Umsetzungsprodukt eines Copolymerisats aus
($a_1$) 5 bis 95 Mol-% eines konjugierten Diens mit 4 bis 6 Kohlenstoffatomen,
($a_2$) 1 bis 50 Mol-% einer α,ß-ethylenisch ungesättigten Carbonsäure und
($a_3$) 5 bis 60 Mol-% einer oder mehrerer polymerisierbarer ethylenisch ungesättigter monomerer organischer Verbindungen, die von den unter ($a_1$) und ($a_2$) genannten verschieden sind,
wobei die Summe der unter ($a_1$) bis ($a_3$) genannten Molprozentzahlen 100 ist, mit einer Verbindung der allgemeinen Formel (II) eingesetzt wird, mit der Maßgabe, daß 1 bis 70 % der Carboxylgruppen des Copolymerisats mit einer Verbindung der Formel (II) umgesetzt sind.

7. Verfahren zur Herstellung von Druckplatten, die gegen Wasser- und Ölfarben resistent sind, dadurch gekennzeichnet, daß lichtempfindliches Aufzeichnungsmaterial gemäß einem der vorhergehenden Ansprüche, gegebenenfalls in gelöster Form, in einer Schichtdicke von 200 µm bis 6 mm auf einen dimensionsstabilen Träger aufgetragen und gegebenenfalls vorhandenes Lösungsmittel entfernt wird.

Europäisches Patentamt

# EUROPÄISCHER RECHERCHENBERICHT

Nummer der Anmeldung

EP 89 11 9801

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | EP-A-0141110 (BASF AKTIENGESELLSCHAFT)<br>* Ansprüche 1-16 *<br>----- | 1-7 | G03F7/031 |
| | | | **RECHERCHIERTE SACHGEBIETE (Int. Cl.5 )** |
| | | | G03F |

Der vorliegende Recherchenbericht wurde für alle Patentansprüche erstellt

| Recherchenort | Abschlußdatum der Recherche | Prüfer |
|---|---|---|
| DEN HAAG | 23 FEBRUAR 1990 | DUPART J-M.B. |

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

1 EPO FORM 1503 03.82 (P0403)